# EUROPÄISCHE PATENTSCHRIFT

(11) **EP 0 623 960 B1**
(45) Veröffentlichungstag und Bekanntmachung des Hinweises auf die Patenterteilung: **16.08.2000**
(21) Anmeldenummer: 94104374.7
(22) Anmeldetag: 19.03.1994
(51) Int. Cl.: H01L 29/739, H01L 29/10, H01L 21/331

(54) **IGBT mit mindestens zwei gegenüberliegenden Kanalgebieten pro Sourcegebiet und Verfahren zu dessen Herstellung**
IGBT having at least two opposite channel regions per source region and method of making the same
IGBT ayant au moins deux régions de canal en vis-à-vis par région de source et sa méthode de fabrication

(30) Priorität: 07.05.1993 DE 4315178
(43) Veröffentlichungstag der Anmeldung: 09.11.1994
(73) Patentinhaber: ABB Semiconductors AG, 5400 Baden (CH)
(72) Erfinder: Bauer, Friedhelm, Dr., CH-5034 Suhr (CH)
(74) Vertreter: ABB Patent Attorneys

(56) Entgegenhaltungen:
- EP-A- 0 405 138
- EP-A- 0 561 267
- DE-A- 3 711 033
- US-A- 4 639 754
- US-A- 4 801 986
- US-A- 4 833 513
- US-A- 5 082 795
- US-A- 5 095 343
- PATENT ABSTRACTS OF JAPAN vol. 10, no. 367 (E-462) (2424) 9. Dezember 1986 & JP-A-61 164 263 (TOSHIBA CORP) 24. Juli 1986

## Beschreibung

### Technisches Gebiet

Die Erfindung bezieht sich auf das Gebiet der Leistungselektronik.

Sie geht aus von einem Bipolartransistor mit isoliertem Gate (IGBT) nach dem Oberbegriff des ersten Anspruchs. Im weiteren betrifft sie ein Verfahren zur Herstellung eines erfindungsgemässen IGBTs.

### Stand der Technik

Ein solcher IGBT wird schon in der EP-A2-0 405 138 beschrieben.

Dieser IGBT umfasst zwischen zwei Hauptflächen, von welchen die eine einer Kathode und die andere einer Anode zugeordnet ist, ein Anzahl unterschiedlich dotierter Halbleiterschichten. Ausgehend von einem n dotierten Halbleitersubstrat folgen in Richtung der Anode eine n+ Stopschicht und ein p Emitter. Der p Emitter ist mit der Anodenmetallisation bedeckt, welche die Anode bildet. Vom Halbleitersubstrat gegen die Kathode hin sind p Kollektorgebiete, welche vorzugsweise streifenförmig ausgebildet sind, in die ersten Hauptfläche eindiffundiert. In diesen Kollektorgebieten sind zudem jeweils mehrere Sourcegebiete eingelassen, welche als Inseln ausgebildet sind und von einem Kanalgebiet, welches unter der Gateelektrode einen Teil des Kollektorgebiet umfasst, bis kurz vor die Mitte des Kollektorstreifens reichen. In einem Kollektorstreifen sind zwei Sourcegebiete von beiden Seiten des Kollektorstreifenrandes wechselseitig gegenüber angeordnet, so dass im Schnitt transversal zum Kollektorstreifen nur ein Kanalgebiet entsteht. Die Sourcegebiete einer Seite des Kollektorstreifens weisen jeweils einen Abstand D auf.

Ziel der eingangs genannten Patentanmeldung ist es nun, einen IGBT sowie ein Verfahren zu dessen Herstellung anzugeben, welcher eine grosse Kurzschlussfestigkeit und eine hohe Unempfindlichkeit gegen Latch-Up aufweist. Dies wird im wesentlichen dadurch erreicht, dass der Abstand D zwischen zwei Sourcegebieten grösser als zweimal die Weite des Kanalgebiets gewählt wird.

Problematisch bleibt bei diesem IGBT aber, dass die Sourceinseln nur bis zu einer gewissen Tiefe in das Kollektorgebiet reichen. Falls die Maske zur Herstellung der Sourcegebiet also etwas fehljustiert ist, so erhält man Sourceinseln, welche auf der einen Seite des Kollektorgebiets weiter und auf der anderen Seite weniger weit ins Kollektorgebiet reichen. Dafür ist auf dieser Seite das Kanalgebiet schmaler. Löcher, welche von der Anode unter den Sourcegebieten hindurch zur Kathode fliessen, sind demgemäss einem unterschiedlichen Widerstand ausgesetzt. Gleichermassen schwankt auch die Latch-Up Resistenz mit der Fehljustierung der Sourceinseln.

Als Folge davon erhält man eine inhomogene Abschaltstromverteilung. Bei einer inhomogenen Abschaltstromverteilung ist die Leistungsfähigkeit des Bauelements nun aber durch den schwächsten Punkt des gesamten Bauelements bestimmt. Das Bauteil darf also nur mit derjenigen Leistung belastet werden, welche dem schwächsten Punkt zugemutet werden kann. Als Folge der Fehljustierung der Sourceinseln erhält man also schlussendlich ein Bauteil mit verminderter Leistungsfähigkeit.

### Darstellung der Erfindung

Aufgabe der vorliegenden Erfindung ist es nun, einen Bipolartransistor mit isoliertem Gate anzugeben, bei welchem eine homogene Abschaltstromverteilung durch eine Struktur erreicht wird, welche vollständig selbstjustierend hergestellt werden kann. Eine weitere Aufgabe besteht darin, ein Herstellungsverfahren für eine solehe selbstjustierte Struktur anzugeben. Diese Aufgabe wird bei einem IGBT der eingangs genannten Art durch die Merkmale der unabhängigen Ansprüche gelöst.

Kern der Erfindung ist es also, dass die Länge L der Sourcegebiete so gross gewählt wird, dass pro Sourcegebiet mindestens zwei gegenüberliegende entstehen. Wird die Breite W der Sourcegebiete ausserdem so gering gewählt, dass Löcher, welche von der Anode unter den Sourcegebieten hindurch zur Kathode fliessen, lateral in das umgebende Kollektorgebiet strömen, und ein Spannungsabfall an einem durch den Löcherfluss vorwärts gepolten PN-Uebergang, welcher gebildet wird durch die Sourcegebiete und die benachbarten Kollektorgebiete, jederzeit unterhalb der eingebauten Schleusenspannung des PN-Uebergangs bleibt. Dies ermöglicht die Verwendung derselben Maske für die Erzeugung der Kollektorgebiete und der Sourcegebiete. Somit sind diese beiden Gebiete stets aufeinander justiert, und zusammen mit der obigen Dimensionierungsvorschrift wird ein IGBT erreicht, der eine homogene Abschaltstromverteilung und eine grösstmögliche Unempfindlichkeit gegen Latch-Up aufweist.

In einem ersten Ausführungsbeispiel sind die Kollektorgebiete streifenförmig ausgebildet und die Sourcegebiete erstrecken sich im wesentlichen über die ganze Breite der Kollektorstreifen, so dass jedes Sourcegebiet auf beiden Seiten je ein Kanalgebiet bildet.

Ein weiteres, bevorzugtes Ausführungsbeispiel zeichnet sich dadurch aus, dass die Kollektorgebiete eine geschlossene Fläche bilden, welche mit Löchern durchsetzt ist, in welchen das Halbleitersubstrat an die Oberfläche tritt. Für diese spezielle Ausführungsform werden verschiedene Strukturen von Sourcegebieten angegeben. Durch die relativ grosse Fläche des zusammenhängenden Kollektorgebiets erhält man ein Bauteil, welches eine erhöhte Sperrspannung aufweist.

Das erfindungsgemässe Verfahren zeichnet sich besonders dadurch aus, dass die Polysiliziumschicht der Gateelektrode als Implantationsmaske für die Kollektorgebiete und zusammen mit einer Lackabdeckung auch als Maske für die Sourcegebiete dient. Dadurch erhält man einen IGBT, dessen Sourcegebiete und Kollektorgebiete selbstjusitiert sind. Demzufolge ergeben sich auch keine Fehljustierungen der Sourcegebiete und eine homogene Abschaltstromverteilung resultiert.

Weitere Ausführungsbeispiele ergeben sich aus den Unteransprüchen.

Der Vorteil des erfindungsgemässen IGBTs besteht also darin, dass die Kathodenstruktur vollständig selbstjustierend hergestellt werden kann und somit eine homogene Abschaltstromverteilung über das Bauelement erreicht werden kann. Damit muss kein Rücksicht auf allfällige, schwächste Punkte im Bauteil genommen werden, und das Bauteil kann mit der Leistung belastet werden, für welches es dimensioniert wurde.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1a**: Die perspektivische Ansicht eines erfindungsgemässen Ausschnitts eines IGBTs nach einer ersten Variante;
- **Fig. 1b**: Einen Ausschnitt von Figur 1a;
- **Fig. 1c**: Den IGBT nach Fig 1a im Schnitt entlang der Ebene A-A;
- **Fig. 2a**: Die perspektivische Ansicht eines erfindungsgemässen Ausschnitts eines IGBTs nach einer zweiten Variante;
- **Fig. 2b**: Einen Ausschnitt von Figur 2a;
- **Fig. 2c**: Den IGBT nach Fig 2a im Schnitt entlang der Ebene B-B;
- **Fig. 3**: Die Draufsicht der Kathodenstruktur eines IGBT nach einem zweiten Ausführungsbeispiel;
- **Fig.4a-f**: Erfindungsgemässe IGBTs im Schnitt in verschiedenen Herstellungs-Stadien.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

Ein erfindungsgemässer IGBT ist aus vielen parallelgeschalteten Einheitszellen zusammengesetzt. Ein Ausschnitt eines IGBTs mit mehreren Einheitszellen ist in Figur 1a perspektivisch dargestellt und umfasst ein Halbleitersubstrat (1) eines ersten, z.B. n-dotierten Leitungstyps. Das Halbleitersubstrat (1) wird durch eine erste (2) und eine zweite (3) Hauptfläche begrenzt. Die zweite Hauptfläche (3) ist der Anodenelektrode (5) zugeordnet, welche durch eine die Hauptfläche (3) bedeckende Metallisierung (11) gebildet wird. Von der anodenseitigen Hauptfläche ist zudem eine Emitterschicht (6) eines zweiten, z.B. p-dotierten Leitungstyps eingelassen. Die erste Hauptfläche (2) ist der Kathodenelektrode zugeordnet, welche durch eine, zwecks besserer Übersicht nicht dargestellte, die erste Hauptfläche (2) bedeckende Metallschicht gebildet wird. In die kathodenseitige Hauptfläche (2) sind weiter Kollektorgebiete (7) eindiffundiert. Diese Kollektorgebiete (7) sind vom zweiten Leitungstyp, d.h. vorzugsweise p-dotiert. In die Kollektorgebiete (7) sind wiederum mehrere Sourcegebiete (8) eindiffundiert, welche ihrerseits vom ersten Leitungstyp, d.h. vorzugsweise n-dotiert sind.

Zwischen den Kollektorgebieten (7) dringt das Halbleitersubstrat (1) an die kathodenseitige Hauptfläche (2) und bildet die sog. n-Basis. Über diesen n-Basis-Gebieten ist, von der kathodenseitigen Hauptfläche durch eine Gateoxidschicht (15) isoliert, eine Gateelektrode (9) angeordnet, welche durch eine leitende, vorzugsweise aus Polysilizium bestehende, Gateelektrodenschicht (11) gebildet wird. Diese Gateelektrodenschicht ist zudem mit einer Gateelektrodenisolation (18) überdeckt, welche die Isolation der Gateelektrode (9) von der Kathode gewährleistet.

Bis jetzt wurde eine konventionelle IGBT-Struktur beschrieben. Der Stromfluss von Anodenelektrode (5) zu Kathodenelektrode kann mit einer solchen Struktur ein- und ausgeschaltet werden, indem die Gateelektrode (9) mit einer Steuerspannung beaufschlagt wird. Durch das Anlegen einer Steuerspannung an das Gate (9) bildet sich zwischen dem Sourcegebiet (8) und dem an die Oberfläche dringenden Halbleitersubstrat ein leitender Kanal im Kollektorgebiet (7). Dieses spezielle Gebiet wird als Kanalgebiet (12) bezeichnet.

Ein IGBT weist im wesentlichen wie ein Bipolartransistor eine Dreischichtstruktur auf, welche durch das Kollektorgebiet (7), das Halbleitersubstrat (1) und den Emitter (6) gebildet wird. Zusätzlich zu dieser Dreischichtstruktur ist aber eine Vierschichtstruktur vorhanden. Dieser parasitäre Thyristor umfasst das Sourcegebiet (8), das Kollektorgebiet (7), das Halbleitersubstrat (1) und den Emitter (6).

Fliesst nun ein Löcherstrom von der Anodenelektrode (5) zur Kathodenelektrode, so strömen die Löcher direkt unter den Sourcegebieten (8) hindurch. Dadurch ergibt sich ein Spannungsabfall. Wenn dieser Spannungsabfall höher als die inhärente Schleusenspannung des PN-Übergangs der Kollektorgebiete (7) und der Sourcegebiete (8) wird, so wird der PN-Übergang vorwärts gepolt und Elektronen werden von den Sourcegebieten (8) in die Kollektorgebiete (7) injiziert. Dies triggert den parasitären Thyristor mit der Folge, dass der Stromfluss durch Anlegen einer Steuerspannung an das Gate (9) nicht mehr gesteuert werden kann. Dieser unerwünschte Effekt wird "Latch-Up" genannt.

Im weiteren sollte ein IGBT eine möglichst hohe Kurzschlussstrombelastbarkeit aufweisen. Diese wird im wesentlichen durch den Abstand der Sourcegebiete bestimmt.

Der Spannungsabfall, welcher zu "Latch-Up" führt, ist unter anderem abhängig von der Länge der Sourcegebiete.

Deshalb wird in der eingangs genannten EP 0 405 138 versucht, einen IGBT gegen Latch-Up resistiver und für Kurzschlüsse belastbarer zu machen, indem die Sourcegebiete in der Länge beschränkt werden und nicht einmal bis zur halben Breite der streifenförmigen Kollektorgebiet reichen, sowie der Abstand zweier Sourcegebiet grösser als die doppelte Weite des Kanalgebiets gewählt wird.

Bei der Herstellung ist es nun aber kaum zu vermeiden, dass die Maske zur Herstellung der Sourcegebiete seitlich etwas fehljustiert ist. Folglich ergeben sich auf der einen Seite Sourcegebiete, welche ein wenig näher zur Mitte der Kollektorgebiete reichen, und auf der anderen Seite Sourcegebiete, welche gegen das Halbleitersubstrat hin verschoben sind.

Dies führt zu einer inhomogenen Abschaltstromverteilung. Damit darf das Bauteil nur mit derjenigen Leistung betrieben werden, welche vom empfindlichsten Punkt ertragen wird. Die Eigenschaften des IGBTs werden somit durch die Fehljustierung der Sourcegebietsmaske drastisch verschlechtert.

Dies kann dadurch vermieden werden, dass, wie in **Figur 1b** dargestellt ist, die Breite W der Sourcegebiete (8) so klein gewählt wird, dass die von der Anode kommenden Löcher nicht entlang der Sourcegebiete (8), sondern lateral in das umgebende Kollektorgebiet (7) strömen können. Die Breite der Sourcegebiete (8) wird also so bemessen, dass selbst im Fall extrem hoher Löcherstromdichten, die Vorwärtspolung des erwähnten PN-Übergangs unterhalb der inhärenten Schleusenspannung bleibt. Damit wir die Injektion von Elektronen und damit "Latch-Up" wirksam verhindert. Die Breite der Sourcegebiete liegt dabei im Bereich von µm.

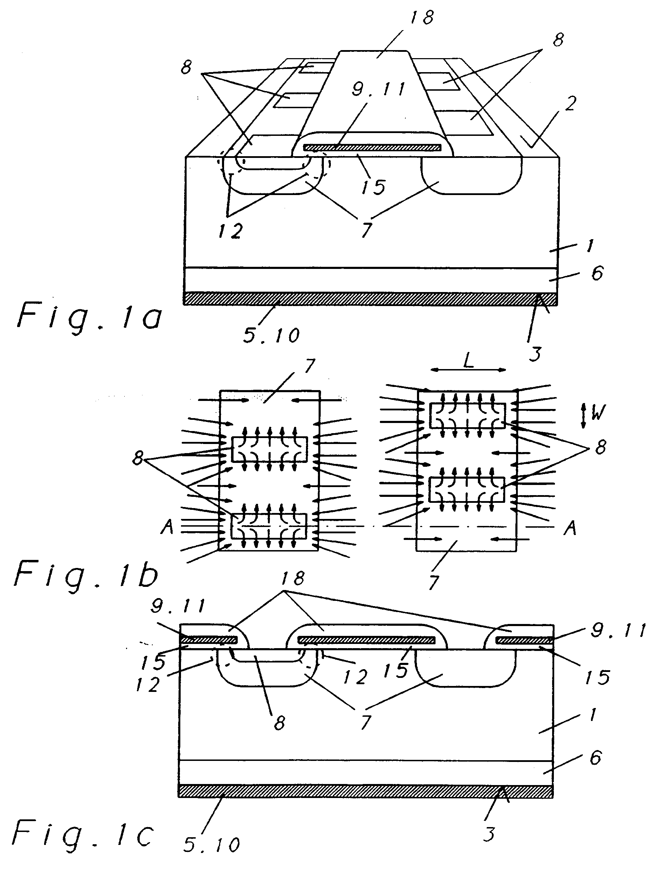

**Figuren 1a und 1c** zeigen eine bevorzugtes Ausführungsbeispiel mit streifenförmiger Anordnung der Kollektorgebiete (7). Bei einer solchen Anordnung wird es nun möglich die Länge L der Sourcegebiete (8) so weit auszudehnen, dass sich die Sourcegebiete (8) praktisch über die gesamte Breite der Kollektorstreifen (7) ausdehnen. Es werden also pro Sourcegebiet (8) mindestens zwei Kanalgebiete (12) gebildet. Damit steht der Weg offen, bei der Herstellung die Polysiliziumschicht sowohl für die Kollektorgebiete (7) als auch für die Sourcegebiete (8) als Injektionsmaske zu verwenden. Demzufolge werden diese beiden Gebiete selbstjustiert und eine Leistungseinbusse wegen Fehljustierung der Sourcegebiete (8) kann nicht mehr auftreten.

In den **Figuren 1a-c** sind die Sourcegebiete (8) von zwei verschiedenen Kollektorgebieten (7) wechselseitig gegenüber angeordnet. Das heisst, dass im einen Kollektorgebiet Sourcegebiete an den Stellen eingelassen sind, wo im anderen Kollektorgebiet Zwischenbereiche des Kollektorgebiets vorhanden sind und umgekehrt.

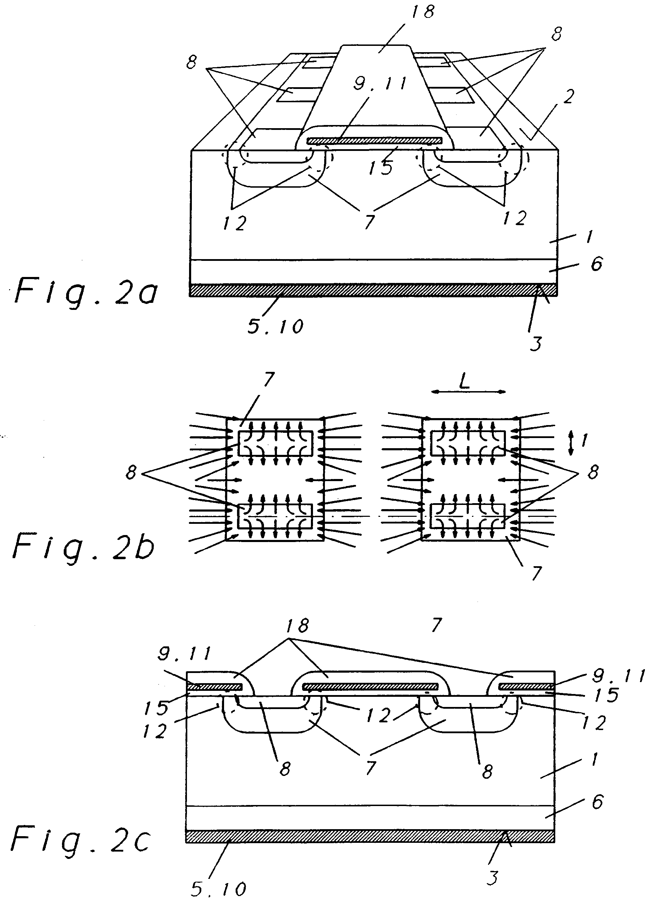

In den **Figuren 2a-c** ist eine weitere Variante dargestellt, welche sich von derjenigen der Figuren 1a-c nur dadurch unterscheidet, dass die Sourcegebiete zweier Kollektorgebiete direkt gegenüber angeordnet sind. Demzufolge sind in den Schnittbildern (entlang der Achsen A-A bzw. B-B) 1c bzw. 2c nur ein bzw. zwei Sourcegebiete (8) dargestellt.

Bei der Anordnung der Sourcegebiete(8) nach den Figuren 1a-c bzw. 2a-c kann darüberhinaus durch weite Zwischenräume zwischen den Sourcegebieten (8) eine vergleichsweise hohe Stromsättigungscharakteristik bzw. ein hohe Kurzschlussstrombelastbarkeit erzielt werden. Dies bedeutet, dass eine vergleichsweise lange Zeitspanne bis zur Detektion des Kurzschlusses toleriert werden kann. Im Fall einer Anwendung der neuartigen Kathodenstruktur für einen Hochspannung-IGBT mit sehr hoher Ladungsträgerlebensdauer und grosser n-Basisweite ist der Anteil des Kanalgebiets (12) am Vorwärtspannungsabfall in erster Näherung vernachlässigbar. Somit ist es durchaus tolerierbar, das Bauelement mit einer minimalen Zahl von Sourcegebieten (dafür maximale Kollektorfläche durch die Kathode kontaktiert) auszulegen.

Zur Erzielung möglichst hoher Sperrspannungen wäre auch für einen IGBT eine Kathodenstruktur erwünscht, welche ähnlich wie beim MCT oder GTO eine grössere Fläche als p-Basis (bzw. Kollektor beim IGBT) besitzt. Mit der erfindungsgemässen Kathodenstruktur kann dies nun auch beim IGBT realisiert werden.

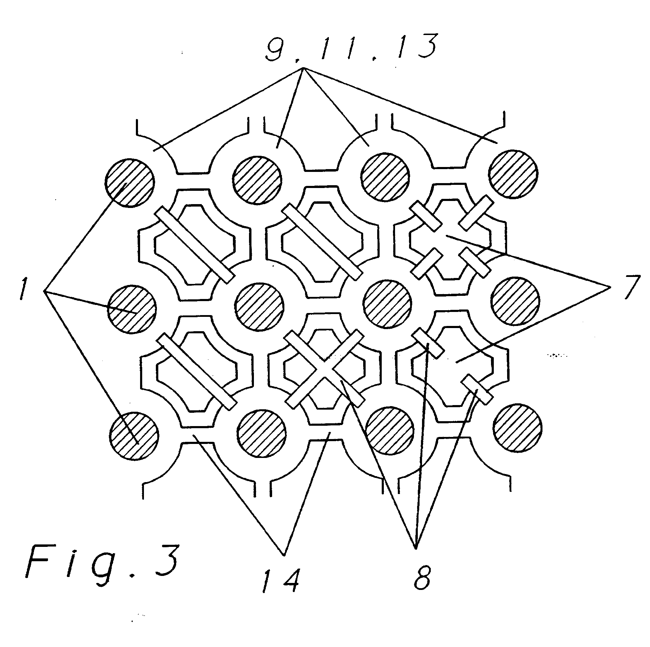

**Figur 3** zeigt eine derartige Realisierung von oben. Dabei ist zu beachten, dass in dieser Figur verschiedene Strukturen wie Masken, Polysiliziumränder, Kollektorgebiete oder Halbleitersubstratabschnitte übereinander gezeichnet sind.

Die Kathodenstruktur nach Figur 3 umfasst ein durchgehendes Kollektorgebiet (7). Diese Kollektorgebiet (7) weist mehrere Löcher auf, in welchen das Halbleitersubstrat (1) an die Oberfläche (2) dringt. Diese Löcher sind mit der Gateoxidschicht (15) (nicht sichtbar) und mit der leitenden Gateschicht (11) bedeckt. Dadurch werden Gateelektrodeninseln (13) gebildet. Der Durchmesser der Gateelektrodeninseln (13) ist grösser als derjenige der an die Oberfläche dringenden Halbleitersubstratteile (1), so dass diese vollständig zugedeckt werden. Benachbarte Gateelektrodeninseln (13) sind über schmale Brücken (14) der leitenden Schicht (11) verbunden. Dieses Netz von mit Brücken (14) verbundenen Gateelektrodeninseln (13) dient als Dotierungsmaske für das zusammenhängende Kollektorgebiet (7). Demzufolge müssen die Brücken (14) so schmal dimensioniert werden, dass bei der Diffusion die lateralen Diffusionsfronten unter den Brücken (14) zusammenfliessen. Typische Werte betragen für die Durchmesser der Gateelektrodeninseln 10 µm bis 20 µm, für die Brückenbreite etwa 3 µm.

Eine solche Kathodenstruktur wird nun mit Sourcegebieten (8) versehen. Deren Breite kann selbstverständlich wie den Ausführungsbeispielen nach Figuren 1a-c und 2a-c gewählt werden. In Figur 3 sind mehrere Möglichkeiten angedeutet. Zum Beispiel sind streifenförmige Sourcegebiete (8) gezeichnet, welche im wesentlichen von einer Gateelektrodeninsel (13) zur diagonal gegenüberliegenden reichen. Gleichermassen können die Sourcegebiete (8) eine kreuzförmige Struktur aufweisen. Ein Teil dieser Strukturen kann auch unterbrochen ausgeführt werden. In diesem Fall reicht das Sourcegebiet (8) von einer Elektrodeninsel (13) sowie von der diagonal gegenüberliegenden Elektrodeninsel (13) je nur zum angrenzenden Kollektorgebiet (7). Auf diese Weise erhält man die Struktur eines unterbrochenen Streifens bzw. eines unterbrochenen Kreuzes.

Stellt man sich nun einen Schnitt vor, welcher von oben links bis unten rechts der Figur 3 entlang der Sourcestreifen (8) vorgenommen wird, so ergibt sich exakt die Struktur, welche in Figur 2c dargestellt ist.

Die vorstehende Erläuterungen wurden am Beispiel von streifen- oder kreuzförmigen Sourcegebieten gemacht. Dies ist jedoch nur der Einfachheit halber geschehen. Ebenso sind andere Formen von Sourcegebieten denkbar, wobei diese so dimensioniert sein können, dass die Löcher seitlich in die umgebenden Kollektorgebiete abströmen können.

Im folgenden wird noch anhand der **Figuren 4a-f** ein Verfahren zur Herstellung eines erfindungsgemässen IGBTs erläutert. Es wird dabei angenommen, dass die Anodenstruktur und ein eventueller Randabschluss, welche beide nicht dargestellt sind, schon erzeugt worden sind.

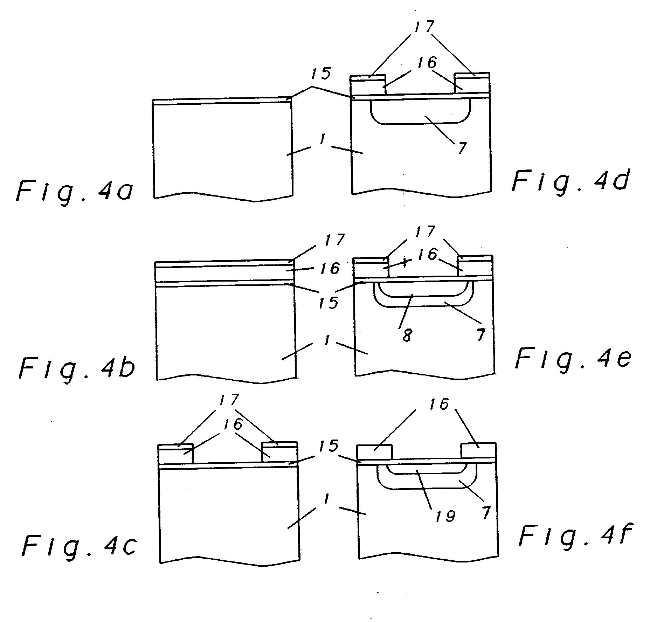

Nach dem Wachsen einer Gateoxidschicht (15), Figur 4a, wird eine Polysiliziumschicht (16) aufgebracht, welche mit einer SiO₂-Maskierschicht (17) abgedeckt wird, Figur 4b. Die Polysiliziumschicht (16) stellt dabei die leitenden Schicht (11) dar und wir später die Gateelektrode (9) bilden. Polysiliziumschicht (16) und Siliziumschicht (17) werden nun an denjenigen Stellen entfernt, an welchen keine Gateelektrode erzeugt werden soll, Figur 4c. Für den nächsten Implantationsschritt mit z.B. Bor oder Boridfluorid und die darauffolgende Eindiffusion wird die strukturierte Polysiliziumschicht (16) als Maske verwendet. Dadurch erhält man das Kollektorgebiet (7), Figur 4d. Die Implantationsdosis ist so zu wählen, dass die geforderte Schleusenspannung erreicht werden kann.

Für die Erfindung wesentlich ist nun, dass dieselbe Polysiliziumschicht (16) auch als Maske für die darauffolgende Sourcegebietimplantation mit Phosphor oder Arsen verwendet wird. Zu diesem Zweck werden die Kollektorgebiete (7) an den Stellen, wo keine Sourcegebiete (8) entstehen sollen mit Lack abgedeckt. Nach der Eindiffusion, welche zugleich die Polysiliziumschicht (16) n+ dotiert, erhält man die Situation, wie sie in Figur 4e dargestellt ist.

Falls die ursprüngliche Dotierung der Kollektorgebiete (7) nicht hinreichend hoch ist, um eine ohmsche Charakteristik der Kathodenkontakte zu ermöglichen, kann anschliessend noch eine flache Hochdosis-Borimplantation vorgenommen werden, Figur 4f. Als Maske dient dazu wiederum die Polysiliziumschicht (16). Dabei ist darauf zu achten, dass die Randkonzentration der Sourcegebiete (8) deutlich (z.B. um den Faktor 5) höher liegt als diejenige der zweiten Borimplantation.

Die darauffolgenden Schritte werden als bekannt vorausgesetzt und umfassen Isolation der Gateelektrode mit der Gateisolationsschicht (18), Kontaktlochöffnung in der Gateoxidschicht (15) sowie Metallisierung der Kathode.

Mit der erfindungsgemässen Verfahren erhält man also IGBTs, deren Kollektorgebiete und Sourcegebiete vollständig selbstjustierend hergestellt werden können. Damit wird das Verfahren einerseits einfach und andererseits kann die Leistungsfähigkeit des Bauteils aufgrund der homogenen Abschaltstromverteilung vollständig ausgenützt werden. Als weiterer Vorteil ist zu betrachten, dass der erfindungsgemässe IGBT aufgrund der speziellen Struktur der Sourcegebiete eine hohe Latch-Up-Resistivität aufweist.

### Bezeichnungsliste

- 1: Halbleitersubstrat
- 2: erste Hauptfläche
- 3: zweite Hauptfläche
- 4: Kathode
- 5: Anode
- 6: Emitterschicht
- 7: Kollektorgebiet
- 8: Sourcegebiet
- 9: Gateelektrode
- 10: Anodenmetallisierung
- 11: Gateelektrodenschicht
- 12: Kanalgebiet
- 13: Gateelektrodeninsel
- 14: Brücke
- 15: Gateoxidschicht
- 16: Polysiliziumschicht
- 17: Maskierschicht
- 18: Gateelektrodenisolation
- 19: p+ Kollektorgebiet

## Patentansprüche

1. Bipolartransistor mit isoliertem Gate umfassend:
a) ein Halbleitersubstrat (1) eines ersten Leitungstyps, welches durch eine erste (2) und eine zweite Hauptfläche (3) begrenzt wird;
b) eine Kathodenelektrode, welche der ersten Hauptfläche (2) zugeordnet ist und von einer die erste Hauptfläche bedeckenden (2) Metallschicht gebildet wird, sowie eine Anodenelektrode (5), welche durch eine die zweite Hauptfläche (3) bedeckende Metallisierung (10) gebildet wird;
c) eine Emitterschicht (6) eines zweiten Leitungstyps, welche von der anodenseitigen Hauptfläche (3) in das Halbleitersubstrat (1) eingelassen ist und von der Anodenelektrode (5) kontaktiert wird;
d) eine Mehrzahl von Kollektorgebieten (7) des zweiten Leitungstyps, welche von der kathodenseitigen Hauptfläche (2) in das Halbleitersubstrat (1) eingelassen sind, wobei das Halbleitersubstrat zwischen zwei benachbarten Kollektorgebieten (7) an die kathodenseitige Hauptfläche (2) dringt;
e) eine Gateelektrode (9), welche durch eine leitende Schicht (11) gebildet wird, welche über der kathodenseitigen Hauptfläche (2) isoliert angeordnet ist und von einem Kollektorgebiet (7) über das an die Oberfläche (2) dringende Halbleitersubstrat (1) zum benachbarten Kollektorgebiet (7) reicht;
f) mehrere Sourcegebiete (8) des ersten Leitungstyps, welche jeweils in den Kollektorgebieten (7) eingelassen sind und welche in Richtung eines benachbarten Kollektorgebietes (7) eine Länge L und rechtwinklig dazu eine Breite W aufweisen, wobei die Sourcegebiete (8) und die Kollektorgebiete (7) von der Kathodenelektrode kontaktiert werden;
g) Kanalgebiete (12), die von der Gateelektrode (9) überdeckt werden und die diejenigen Teile der Kollektorgebiete (7) umfassen, zwischen denen die Sourcegebiete (8) an die erste Hauptfläche (2) dringen;
dadurch gekennzeichnet, dass
h) die Länge L der Sourcegebiete (8) so gross ist, dass pro Sourcegebiet (8) mindestens zwei gegenüberliegende Kanalgebiete (12) entstehen.

2. Bipolartransistor nach Anspruch 1, dadurch gekennzeichnet, dass die Sourcegebiete (8) zweier benachbarter Kollektorgebiete (7) derart angeordnet sind, dass in dem einem Kollektorgebiet Sourcegebiete an den Stellen eingelassen sind, an denen im anderen Kollektorgebiet keine Sourcegebiete vorgesehen sind und umgekehrt.

3. Bipolartransistor nach Anspruch 1, dadurch gekennzeichnet, dass die Sourcegebiete (8) zweier benachbarter Kollektorgebiete (7) jeweils direkt gegenüber angeordnet sind.

4. Bipolartransistor mit isoliertem Gate umfassend
a) ein Halbleitersubstrat (1) eines ersten Leitungstyps, welches durch eine erste (2) und eine zweite Hauptfläche (3) begrenzt wird;
b) eine Kathodenelektrode, welche der ersten Hauptfläche (2) zugeordnet ist und von einer die erste Hauptfläche bedeckende (2) Metallschicht gebildet wird, sowie eine Anodenelektrode (5), welche durch eine die zweite Hauptfläche (3) bedeckende Metallisierung (10) gebildet wird;
c) eine Emitterschicht (6) eines zweiten Leitungstyps, welche von der anodenseitigen Hauptfläche (3) in das Halbleitersubstrat (1) eingelassen ist und von der Anodenelektrode (5) kontaktiert wird; d) ein durchgehendes Kollektorgebiet (7) des zweiten Leitungstyps, welches von der kathodenseitigen Hauptfläche (2) in das Halbleitersubstrat (1) eingelassen ist;
e) eine Gateelektrode (9), welche durch eine leitende Schicht (11) gebildet wird, und welche über der kathodenseitigen Hauptfläche (2) isoliert angeordnet ist;
f) mehrere Sourcegebiete (8) des ersten Leitungstyps, welche in dem Kollektorgebiet (7) eingelassen sind und welche eine Länge L und rechtwinklig dazu eine Breite W aufweisen, wobei die Sourcegebiete (8) und das Kollektorgebiet (7) von der Kathodenelektrode kontaktiert werden;
g) Kanalgebiete (12), die von der Gateelektrode (9) überdeckt werden und die diejenigen Teile des Kollektorgebietes (7) umfassen, welche zwischen denen die Sourcegebiete (8) an die erste Hauptfläche (2) dringen;
bei dem
h) die Länge L der Sourcegebiete (8) so gross ist, dass pro Sourcegebiet (8) mindestens zwei gegenüberliegende Kanalgebiete (12) entstehen;
i) das Kollektorgebiet (7) eine geschlossene Fläche bildet, wobei diese Fläche mehrere Löcher aufweist, in welchen das Halbleitersubstrat (1) an die kathodenseitige Oberfläche (2) tritt;
j) diese Löcher mit der leitenden Gateelektrodenschicht (11) bedeckt sind und Gateelektrodeninseln (13) bilden;
k) und zwei benachbarte Gateelektrodeninseln (13) über Brücken (14) der leitenden Schicht (11) verbunden sind.

5. Bipolartransistor nach Anspruch 4, dadurch gekennzeichnet, dass die Gateelektrodeninseln (13) die Form eines Kreises oder eines Polygons, insbesondere eines Hexagons aufweisen.

6. Bipolartransistor nach einem der Ansprüche 4-5, dadurch gekennzeichnet, dass die Sourcegebiete (8) als Streifen ausgeführt sind, welche von einer Gateelektrodeninsel (13) zur diagonal gegenüberliegenden reichen.

7. Bipolartransistor nach einem der Ansprüche 4-5, dadurch gekennzeichnet, dass die Sourcegebiete (8) als Kreuze ausgeführt sind, welche von einer Gateelektrodeninsel (13) zur diagonal gegenüberliegenden reichen.

8. Bipolartransistor nach einem der Ansprüche 4-5, dadurch gekennzeichnet, dass die Sourcegebiete (8) als unterbrochene Streifen ausgeführt sind, welche einerseits von einer ersten Gateelektrodeninsel (13) zum angrenzenden Kollektorgebiet (7) und andererseits von der diagonal gegenüberliegenden Gateelektrodeninsel (13) zum diesem Kollektorgebiet (7) reichen.

9. Bipolartransistor nach einem der Ansprüche 4-5, dadurch gekennzeichnet, dass die Sourcegebiete (8) als unterbrochene Kreuze ausgeführt sind, welche von jeder Gateelektrodeninsel (13) zum angrenzenden Kollektorgebiet (7) reichen.

10. Verfahren zur Herstellung eines Bipolartransistor nach Anspruch 1, Anodenelektrode bei dem nach der Erzeugung der (5) und eines allfälligen Randabschlusses die kathodenseitige Oberfläche (2) mittels folgender Schritte strukturiert wird:
a) Deposition einer Gateoxidschicht (15);
b) Deposition einer Polysiliziumschicht (16), welche mit einer SiO₂-Maskierschicht (17) abgedeckt wird;
c) Entfernen der Polysiliziumschicht (16) an den Stellen, an denen keine Gateelektrode (9) erzeugt werden soll;
d) Implantation und Diffusion der Kollektorgebiete (7), wobei die Polysiliziumschicht (16) als Implantationsmaske dient;
e) Abdecken der Kollektorgebiete (7) mit Lack an den Stellen, wo kein Sourcegebiet (8) entstehen soll;
f) Implantation und Diffusion der Sourcegebiete sowie gleichzeitige Dotierung der Polysiliziumschicht (16) zur Gateelektrode (9), wobei die Polysiliziumschicht (16) für die Sourcegebiete wiederum als Implantationsmaske dient; sowie
g) Isolation der Gateelektrode, Kontaktlochöffnung, und Metallisierung der
Kathodenelektrode.

11. Verfahren nach Anspruch 11, bei dem die Kollektorgebiete (7) nach der Implantation und Diffusion der Sourcegebiete einem zusätzlichen Implantationsschritt unterworfen werden.

## Claims

1. Insulated-gate bipolar transistor comprising
a) a semiconductor substrate (1) of a first conduction type which is bounded by a first (2) and a second main area (3);
b) a cathode electrode which is allocated to the first main area (2) and is formed by a metal layer covering (2) [sic] the first main area, and an anode electrode (5) which is formed by a metallization (10) covering the second main area (3) ;
c) an emitter layer (6) of a second conduction type which is inserted into the semiconductor substrate (1) from the anode-side main area (3) and is contacted by the anode electrode (5);
d) a plurality of collector regions (7) of the second conduction type which are inserted into the semiconductor substrate (1) from the cathode-side main area (2), the semiconductor substrate penetrating to the cathode-side main area (2) between two adjacent collector regions (7);
e) a gate electrode (9) which is formed by a conducting layer (11) which is arranged insulated above the cathode-side main area (2) and extends from a collector region (7) over the semiconductor substrate (1) penetrating to the surface (2) to the adjacent collector region (7);
f) a number of source regions (8) of the first conduction type which are in each case inserted in the collector regions (7) and which exhibit a length L and at right angles thereto a width W in the direction of an adjacent collector region (7), the source regions (8) and the collector regions (7) being contacted by the cathode electrode;
g) channel regions (12) which are covered by the gate electrode (9) and which comprise the parts of the collector regions (7) between which the source regions (8) penetrate to the first main area (2);
characterized in that
h) the length L of the source regions (8) is so great that at least two opposite channel regions (12) are produced per source region (8).

2. Bipolar transistor according to Claim 1, characterized in that the source regions (8) of two adjacent collector regions (7) are arranged in such a manner that source regions are inserted in the one collector region at the locations where no source regions are provided in the other collector region, and conversely.

3. Bipolar transistor according to Claim 1, characterized in that the source regions (8) of two adjacent collector regions (7) are in each case arranged to be directly opposite.

4. Insulated-gate bipolar transistor comprising
a) a semiconductor substrate (1) of a first conduction type which is bounded by a first (2) and a second main area (3);
b) a cathode electrode which is allocated to the first main area (2) and is formed by a metal layer covering (2) [sic] the first main area, and an anode electrode (5) which is formed by a metallization (10) covering the second main area (3);
c) an emitter layer (6) of a second conduction type which is inserted into the semiconductor substrate (1) from the anode-side main area (3) and is contacted by the anode electrode (5);
d) a continuous collector region (7) of the second conduction type which is inserted into the semiconductor substrate (1) from the cathode-side main area (2);
e) a gate electrode (9) which is formed by a conducting layer (11) and which is arranged insulated above the cathode-side main area (2);
f) a number of source regions (8) of the first conduction type which are inserted in the collector region (7) and which exhibit a length L and at right angles thereto a width W, the source regions (8) and the collector region (7) being contacted by the cathode electrode;
g) channel regions (12) which are covered by the gate electrode (9) and which comprise the parts of the collector region (7) which [sic] between which the source regions (8) penetrate to the first main area (2);
in which
h) the length L of the source regions (8) is so great that at least two opposite channel regions (12) are produced per source region (8);
i) the collector region (7) forms a closed area, this area exhibiting a number of holes in which the semiconductor substrate (1) penetrates to the cathode-side surface (2);
j) these holes are covered with the conducting gate electrode layer (11) and form gate electrode islands (13);
k) and two adjacent gate electrode islands (13) are connected via bridges (14) of the conducting layer (11).

5. Bipolar transistor according to Claim 4, characterized in that the gate electrode islands (13) exhibit the form of a circle or of a polygon, especially of a hexagon.

6. Bipolar transistor according to one of Claims 4-5, characterized in that the source regions (8) are designed as strips which extend from one gate electrode island (13) to the diagonally opposite one.

7. Bipolar transistor according to one of Claims 4-5, characterized in that the source regions (8) are designed as crosses which extend from one gate electrode island (13) to the diagonally opposite one.

8. Bipolar transistor according to one of Claims 4-5, characterized in that the source regions (8) are designed as interrupted strips which, on the one hand, extend from a first gate electrode island (13) to the adjoining collector region (7) and, on the other hand, from the diagonally opposite gate electrode island (13) to this collector region (7).

9. Bipolar transistor according to one of Claims 4-5, characterized in that the source regions (8) are designed as interrupted crosses which extend from each gate electrode island (13) to the adjoining collector region (7).

10. Method for producing a bipolar transistor according to Claim 1, in which, after creation of the anode electrode (5) and any edge termination, the cathode-side surface (2) is patterned by means of the following steps:
a) deposition of a gate oxide layer (15);
b) deposition of a polysilicon layer (16) which is covered with an SiO₂ masking layer (17);
c) removal of the polysilicon layer (16) at the locations where no gate electrode (9) is to be created;
d) implantation and diffusion of the collector regions (7), the polysilicon layer (16) being used as implantation mask;
e) covering of the collector regions (7) with resist at the locations where no source region (8) is to be created;
f) implantation and diffusion of the source regions and simultaneous doping of the silicon layer (16) to become the gate electrode (9), the polysilicon layer (16) for the source regions, in turn, being used as implantation masks; and
g) insulation of the gate electrode, contact hole opening and metallization of the cathode electrode.

11. Method according to Claim 11 [sic], in which the collector regions (7) are subjected to an additional implantation step after the implantation and diffusion of the source regions.

## Revendications

1. Transistor bipolaire avec porte isolée comprenant :
a) un substrat semiconducteur (1) d'un premier type de conduction, lequel est délimité par une première (2) et une deuxième surface principale (3) ;
b) une électrode de cathode qui est associée à la première surface principale (2) et qui est formée par une couche métallique qui recouvre la première surface principale (2), ainsi qu'une électrode d'anode (5) qui est formée par une métallisation (10) qui recouvre la deuxième surface principale (3) ;
c) une couche d'émetteur (6) d'un deuxième type de conduction, laquelle pénètre dans le substrat semiconducteur (1) depuis la surface principale (3) côté anode et est en contact avec l'électrode d'anode (5) ;
d) une pluralité de régions de collecteur (7) du deuxième type de conduction, lesquelles pénètrent dans le substrat semiconducteur (1) depuis la surface principale (2) côté cathode, le substrat semiconducteur rejoignant la surface principale (2) côté cathode entre deux régions de collecteur (7) voisines ;
e) une électrode de porte (9) qui est formée par une couche conductrice (11), laquelle est disposée de manière isolée sur la surface principale (2) côté cathode et s'étend d'une région de collecteur (7) à la région de collecteur (7) voisine au-dessus du substrat semiconducteur (1) qui rejoint la surface (2) ;
f) plusieurs régions de source (8) du premier type de conduction, lesquelles pénètrent chacune dans les régions de collecteur (7) et présentent une longueur L en direction d'une région de collecteur (7) voisine ainsi qu'une largeur W perpendiculaire à celle-ci, les régions de source (8) et les régions de collecteur (7) étant mises en contact par l'électrode de cathode ;
g) des régions de canal (12) qui sont recouvertes par l'électrode de porte (9) et qui entourent les parties des régions de collecteur (7) entre lesquelles les régions de source (8) rejoignent la première surface principale (2) ;
caractérisé par le fait que
h) la longueur L des régions de source (8) est suffisamment grande pour produire au moins deux régions de canal (12) en vis-à-vis pour chaque région de source (8).

2. Transistor bipolaire selon la revendication 1, caractérisé par le fait que les régions de source (8) de deux régions de collecteur (7) voisines sont disposées de telle manière que les régions de source pénètrent dans l'une des régions de collecteur à aux endroits où aucune région de source n'est prévue dans l'autre région de collecteur et inversement.

3. Transistor bipolaire selon la revendication 1, caractérisé par le fait que les régions de source (8) de deux régions de collecteur (7) voisines sont à chaque fois disposées directement l'une au-dessus de l'autre.

4. Transistor bipolaire avec porte isolée comprenant :
a) un substrat semiconducteur (1) d'un premier type de conduction, lequel est délimité par une première (2) et une deuxième surface principale (3) ;
b) une électrode de cathode qui est associée à la première surface principale (2) et qui est formée par une couche métallique qui recouvre la première surface principale (2), ainsi qu'une électrode d'anode (5) qui est formée par une métallisation (10) qui recouvre la deuxième surface principale (3) ;
c) une couche d'émetteur (6) d'un deuxième type de conduction, laquelle pénètre dans le substrat semiconducteur (1) depuis la surface principale (3) côté anode et est en contact avec l'électrode d'anode (5) ;
d) une région de collecteur (7) traversante du deuxième type de conduction, laquelle pénètre dans le substrat semiconducteur (1) depuis la surface principale (2) côté cathode ;
e) une électrode de porte (9) qui est formée par une couche conductrice (11) , et qui est disposée de manière isolée au-dessus de la surface principale (2) côté cathode ;
f) plusieurs régions de source (8) du premier type de conduction, lesquelles pénètrent dans la région de collecteur (7) et présentent une longueur L et une largeur W perpendiculaire à celle-ci, les régions de source (8) et la région de collecteur (7) étant mises en contact par l'électrode de cathode ;
g) des régions de canal (12) qui sont recouvertes par l'électrode de porte (9) et qui entourent les parties des régions de collecteur (7) entre lesquelles les régions de source (8) rejoignent la première surface principale (2) ;
avec lequel
h) la longueur L des régions de source (8) est suffisamment grande pour produire au moins deux régions de canal (12) an vis-à-vis pour chaque région de source (8) ;
i) la région de collecteur (7) forme une surface fermée, cette surface présentant plusieurs trous à travers lesquels le substrat semiconducteur (1) rejoint la surface (2) côté cathode ;
j) ces trous sont recouverts par la couche d'électrode de porte (11) conductrice et forment des îlots d'électrode de porte (13) ;
k) et deux îlots d'électrode de porte (13) voisins sont reliés par des cavaliers (14) de la couche conductrice (11).

5. Transistor bipolaire selon la revendication 4, caractérisé par le fait que les îlots d'électrode de porte (13) présentent la forme d'un cercle ou d'un polygone, plus particulièrement d'un hexagone.

6. Transistor bipolaire selon l'une des revendications 4 ou 5, caractérisé par le fait que les régions de source (8) sont réalisées sous la forme de bandes qui s'étendent d'un îlot d'électrode de porte (13) vers celui diagonalement opposé.

7. Transistor bipolaire selon l'une des revendications 4 ou 5, caractérisé par le fait que les régions de source (8) sont réalisées sous la forme de bandes qui s'étendent d'un îlot d'électrode de porte (13) vers celui diagonalement opposé.

8. Transistor bipolaire selon l'une des revendications 4 ou 5, caractérisé par le fait que les régions de source (8) sont réalisées sous la forme de bandes interrompues qui s'étendent d'un côté, d'un premier îlot d'électrode de porte (13) vers la région de collecteur (7) voisine et de l'autre côté, de l'îlot d'électrode de porte (13) diagonalement opposé vers cette région de collecteur (7).

9. Transistor bipolaire selon l'une des revendications 4 ou 5, caractérisé par le fait que les régions de source (8) sont réalisées sous la forme de croix interrompues qui s'étendent de chaque îlot d'électrode de porte (13) vers la région de collecteur (7) voisine.

10. Méthode de fabrication d'un transistor bipolaire selon la revendication 1, avec laquelle la surface côté cathode (2) est structurée au moyen des étapes suivantes après avoir produit l'électrode d'anode (5) et une éventuelle finition de bordure :
a) déposition d'une couche d'oxyde de porte (15) ;
b) déposition d'une couche de polysilicium (16) qui est recouverte d'une couche de masquage au SiO₂ (17) ;
c) enlèvement de la couche de polysilicium (16) aux endroits où il ne faut pas produire d'électrode de porte (9) ;
d) implantation et diffusion des régions de collecteur (7), la couche de polysilicium (16) faisant office de masque d'implantation ;
e) recouvrement des régions de collecteur (7) avec du vernis aux endroits où il ne faut pas produire de région de source (8) ;
f) implantation et diffusion des régions de source et dopage simultané de la couche de polysilicium (16) en direction de l'électrode de porte (9), la couche de polysilicium (16) faisant à nouveau office de masque d'implantation pour les régions de source ; et
g) isolation de l'électrode de porte, ouverture du trou de contact et métallisation de l'électrode de cathode.

11. Méthode selon la revendication 10 avec laquelle les régions de collecteur (7) sont soumises à une étape d'implantation supplémentaire après l'implantation et la diffusion des régions de source.
